**Europäisches Patentamt**

**European Patent Office**

**Office européen des brevets**

(11) Numéro de publication : **0 397 564 B1**

(12) # FASCICULE DE BREVET EUROPEEN

(45) Date de publication du fascicule du brevet :
**22.02.95 Bulletin 95/08**

(51) Int. Cl.[6] : **G10L 7/00**

(21) Numéro de dépôt : **90401233.3**

(22) Date de dépôt : **09.05.90**

---

(54) **Procédé et installation à codage de signaux sonores.**

---

(30) Priorité : **11.05.89 FR 8906194**

(43) Date de publication de la demande :
**14.11.90 Bulletin 90/46**

(45) Mention de la délivrance du brevet :
**22.02.95 Bulletin 95/08**

(84) Etats contractants désignés :
**DE GB IT NL**

(56) Documents cités :
**EP-A- 0 385 799**
**DE-C- 3 310 480**
**US-A- 4 592 070**
**1978 IEEE INTERNATIONAL CONFERENCE ON ACOUSTICS, SPEECH AND SIGNAL PROCESSING,Tulsa, Oklahoma, 10-12 avril 1978, pages 338-340, IEEE, New York, US; A.K.JAIN: "Two dimensional data compression of speech"**

(56) Documents cités :
**ICASSP'89, 1989 INTERNATIONAL CONFERENCE ON ACOUSTICS, SPEECH AND SIGNALPROCESSING, Glasgow, 23-26 mai 1989, vol. 1, pages 168-171, IEEE, New York, US;N. FARVARDIN et al.: "Efficient encoding of speech LSP parameters using thediscrete cosine transformation"**
**ICASSP'87, 1987 INTERNATIONAL CONFERENCE ON ACOUSTICS, SPEECH AND SIGNALPROCESSING, Dallas, 6-9 avril 1987, vol. 1, pages 141-144, IEEE, new York, US;K. BRANDENBURG: "OCF - A new coding algorithm for high quality sound signals"**
**FREQUENZ, vol. 34, no. 10, octobre 1984, pages 247-254, Berlin, DE; T.-A.VUONG: "Entwurf eines blockweise adaptiven DPCM-coders für die M-Spektralwertevon Bilddaten"**

(73) Titulaire : **FRANCE TELECOM**
**6, Place d'Alleray**
**F-75015 Paris (FR)**

(72) Inventeur : **Mahieux, Yannick**
**La Grée Saint Laurent**
**F-56120 Josselin (FR)**
Inventeur : **Charbonnier, Alain**
**13, rue Saint Symphorien**
**F-78000 Versailles (FR)**

(74) Mandataire : **Fréchède, Michel et al**
**Cabinet Plasseraud**
**84, rue d'Amsterdam**
**F-75009 Paris (FR)**

---

## Description

L'invention concerne la transmission ou le stockage sous forme numérique de signaux sonores, notamment de signaux audio de haute qualité. Elle concerne plus particulièrement les procédés du type suivant lequel on découpe le signal sonore en blocs d'échantillons et on soumet les échantillons de chaque bloc à un codage par transformée temps-fréquence dont on transmet les coefficients sous forme numérique, les opérations inverses étant effectuées à la réception.

Les procédés connus du type ci-dessus résolvent partiellement le problème de la transmission ou de la mémorisation sous forme numérique des signaux sonores de haute qualité dont la largeur de bande dépasse 15 kHz et qui exigent, en cas de codage direct dans le domaine temporel, un débit numérique trop élevé. Le codage par transformée temps-fréquence, notamment par transformée de Fourier discrète (TFD) ou par transformée en cosinus discrète tirent profit de la stationnarité à court terme de beaucoup de signaux physiques, et notamment des signaux audio. Dans ce dernier cas, on découpe en général le signal constitué d'échantillons numériques, en blocs ayant une durée de quelques dizaines de millisecondes (de 16 ou de 32 ms en général) et on effectue une transformation temps-fréquence qui donne naissance à des raies qui sont codées à leur tour par l'un des procédés classiques adaptés au canal de transmission utilisé. L'utilisation d'une transformée réduit la redondance à court terme des variables à coder et permet en particulier de réduire le débit requis pour une restitution satisfaisante ; on ne code en effet avec une précision élevée que les raies spectrales correspondant aux fréquences où l'énergie est concentrée. On peut ainsi reconstituer le signal de départ avec un bruit réduit.

Lorsque le procédé est appliqué à la transmission et à la restitution des signaux audio de haute qualité, il procure un avantage supplémentaire dû à un phénomène psycho-acoustique. On obtient une restitution subjectivement satisfaisante même si certaines fréquences, masquées par l'énergie concentrée sur les autres, ne sont codées qu'avec une précision réduite.

Le procédé ci-dessus, connu depuis longtemps et dont on trouvera par exemple une description dans l'article de ZELINSKI et autres "Adaptative Transform Coding of Speech Signals", IEEE Transactions on Acoustics Speech and Signal Processing, Vol. ASSP-25, n° 4, Août 1977 traite chaque bloc d'échantillon sans aucune référence aux blocs adjacents. La réduction de débit qu'il permet d'obtenir est en conséquence limitée. En effet il faut, pour chaque bloc, transmettre non seulement les coefficients, mais aussi une information auxiliaire décrivant le spectre afin que le codeur et le décodeur allouent le même nombre de bits (c'est-à-dire de niveaux de quantification) aux coefficients correspondants ; cette information auxiliaire, qui constitue un descripteur de spectre, accapare une partie significative du débit disponible (15 à 20 % en général).

L'invention vise notamment à fournir un procédé permettant de diminuer encore le débit nécessaire. Pour cela elle part de la constatation que les signaux sonores présentent, en plus de la redondance à court terme qui est utilisée dans le codage par transformée temps-fréquence, une redondance à moyen terme très variable. Ainsi, dans le cas de transmission de signaux audio, la durée de stationnarité des signaux audio est inférieure à 100ms pour des passages très rapides et dépasse la seconde pour des notes soutenues.

Cette durée est généralement supérieure à la longueur du bloc d'échantillons soumis à la transformée.

Un tel procédé a notamment été décrit par le document ICASSP 78, IEEE International Conference on Acoustics, Speech & Signal Processing, April 10-12, 1978 CAMELOT INN TULSA OKLAHOMA.

Dans le procédé décrit par ce document, le signal de parole est découpé en blocs d'échantillons, les échantillons de chaque bloc étant soumis à un codage par transformée temps-fréquence, les coefficients de transformée de chaque bloc étant soumis à un codage prédictif, utilisant la stationnarité du signal sur une durée supérieure à celle d'un bloc. Il en résulte une redondance plus ou moins forte entre les spectres successifs. Cette redondance est particulièrement élevée pour les parties du spectre à forte énergie, c'est-à-dire pour celles nécessitant la précision de codage la plus élevée.

De plus, l'expérience montre que l'appareil auditif est particulièrement sensible aux variations des sons fortement résonnants, du fait qu'il semble s'habituer à une forme spectrale et est alors capable de détecter de très faibles variations du son en intensité et surtout en hauteur. Ces très faibles variations doivent en conséquence être exactement transmises et restituées, ce qui implique d'affecter un nombre important de bits aux fréquences correspondantes. Mais ces sons soutenus ou fortement résonnants, auxquels il faut attribuer un grand nombre de bits, présentent justement une redondance inter-blocs élevée dont ne profite pas le procédé défini plus haut.

L'invention vise notamment à fournir un procédé de transmission du type ci-dessus défini répondant mieux que ceux antérieurement connus aux exigences de la pratique, notamment en ce qu'il permet de réduire le débit d'informations requis, à qualité de restitution égale.

Dans ce but l'invention propose un procédé tel que revendiqué à la revendication 1. Suivant ce procédé, on soumet au moins les coefficients les plus significatifs de la transformée de chaque bloc à un codage prédictif et adaptatif utilisant la stationnarité du signal sur une durée supérieure à celle d'un bloc.

On associe alors :
- un codage prédictif et adaptatif des harmoniques intenses du signal, et
- un codage des raies spectrales moins significatives de la transformée par quantification adaptative non uniforme du module et quantification fixe et uniforme de la phase.

L'invention propose également un codeur et un décodeur, ainsi qu'une installation complète de transmission, utilisables pour mettre en oeuvre le procédé ci-dessus défini.

Le codeur prédictif et adaptatif du module peut avoir une constitution générale classique avec un ordre de prédiction d'ordre 1 et un quantificateur non uniforme. Le codeur de la phase peut, lui, avoir deux boucles différentielles imbriquées et un quantificateur adaptatif uniforme.

L'invention sera mieux comprise à la lecture de la description qui suit d'un mode particulier de réalisation, donné à titre d'exemple non limitatif. La description se réfère aux dessins qui l'accompagnent, dans lesquels :
- la Figure 1 est un synoptique de principe d'une installation de transmission suivant l'art antérieur, mettant en oeuvre la transformée temps-fréquence ;
- les Figures 2A et 2B sont respectivement des synoptiques d'un codeur et d'un décodeur prédictifs du module des coefficients, incorporables dans l'installation de la Figure 1 pour mettre en oeuvre l'invention ;
- les Figures 3A et 3B sont respectivement des synoptiques d'un codeur et d'un décodeur prédictifs de la phase des harmoniques, également incorporables dans l'installation de la Figure 1 pour mettre en oeuvre l'invention ;
- la Figure 4 est un synoptique d'ensemble d'une installation suivant l'invention.

Avant de décrire l'invention, on rappellera la constitution des composants concernés par elle d'une installation de transmission de type connu, utilisant un codage par transformation temps-fréquence.

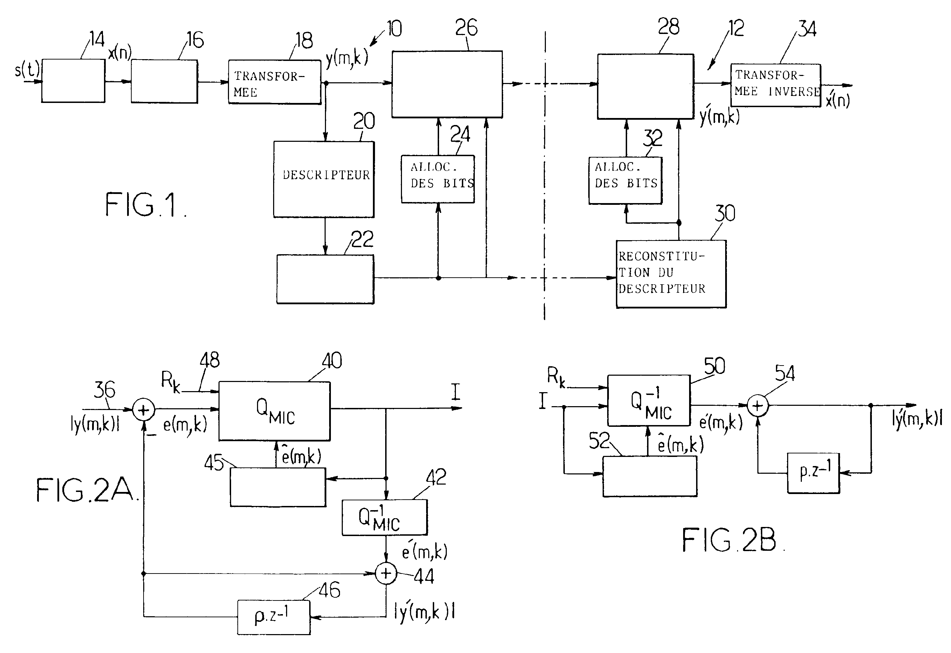

L'installation schématisée en Figure 1 comporte un émetteur et un récepteur, reliés par un canal de transmission, non représenté, qui peut être de nature hertzienne ou filaire. L'émetteur contient un codeur 10 qui reçoit le signal d'entrée analogique s(t) par l'intermédiaire d'un échantillonneur 14. Dans le cas de la transmission de signaux audio de haute qualité, une cadence d'échantillonnage de 32 kHz à 48 kHz sera généralement utilisée. Le codeur comprend un circuit de découpage en blocs 16 qui reçoit les échantillons d'entrée x(n) et les répartit en blocs successifs $\{x(n)\}$ d'ordre $m = 0, 1, 2,...$ constitués chacun de N échantillons et d'une durée qui est en général de 16 ou 32 ms dans le cas d'un signal audio. Chaque bloc $\{x(n)\}$ est indépendamment soumis à une transformation temps-fréquence par un circuit de transformation 18 qui fournit, en sortie, des coefficients complexes désignés par y(m,k) pour le bloc d'ordre m avec $k = 0,1,..., N/2$. Chaque bloc est traité de façon totalement indépendante des autres.

Dans ce qui suit, on supposera que le circuit 18 fournit une transformée de Fourier discrète (TFD), mais d'autres transformations seraient utilisables, notamment la transformation en cosinus discrète (TCD).

Les coefficients complexes affectés à chaque bloc sont de la forme :
$$y(m,k) = |y(m,k)| \exp[j\varphi(m,k)] \quad (1)$$
où y(m,k) est calculé suivant la formule :

$$y(m,k) = \frac{1}{N} \sum_{n=mN}^{(m+1)N-1} x(n) \exp(-j\, 2\pi kn/N) \quad (2)$$

Les modules des différents coefficients représentent la répartition fréquentielle de l'énergie dans un bloc. La redondance à long terme du signal, qui apparaît dans la formule (2), n'est pas prise en compte par le codeur de la Figure 1.

En ce qui concerne la phase $\varphi(m,k)$, la stationnarité du signal à long terme, c'est-à-dire sur un intervalle de temps dépassant la durée d'un bloc apparaît au niveau de la fréquence instantanée du signal. Elle apparaît immédiatement si l'on considère le cas particulier d'un signal sinusoïdal à fréquence f, échantillonné avec une période $T_s$. Les échantillons x(n) d'un tel signal sont de la forme :
$$x(n) = A\cos(2\pi f n T_s + \theta) \quad (3)$$
La différence de phase $\Delta\varphi(k)$ entre un coefficient d'ordre k de la TFD $y(m_1,k)$ calculée sur un bloc d'échantillons de dimension N et le coefficient correspondant $y(m_2,k)$ pour un bloc de même dimension, décalé de M échantillons par rapport au premier est alors :
$$\Delta\varphi(k) = \varphi(m_2,k) - \varphi(m_1,k) = 2\pi fM T_s \quad (4).$$
On voit sur la formule (4) que la différence temporelle des phases contient une information sur la fréquence instantanée f du signal sinusoïdal. L'information sur la fréquence ne peut toutefois être obtenue que dans un domaine d'écart limité, car les phases φ, et donc la différence Δφ, ne sont disponibles que modulo $2\pi$. La différence de phase mesurable est liée à la différence entre la fréquence instantanée du signal f et une fréquence $f_a$ fonction de l'espacement entre les blocs par la relation :

$$\Delta\varphi(k) = f - f_a$$

où $1/f_a$ est le nombre entier de périodes du signal sinusoïdal pendant la durée M $T_s$.

Dans le cas fréquent où les blocs successifs sont adjacents, c'est-à-dire où M = N, $f_a$ est un multiple de la résolution fréquentielle de la TFD.

Dans le cas d'un signal stationnaire, dont le spectre reste pratiquement inchangé au cours du temps, Δφ reste presque constant.

Par contre, Δφ peut avoir des variations rapides dans le cas de signaux audio particuliers et de transitions entre des signaux de natures différentes.

Le codeur selon l'art antérieur montré en Figure 1 est à quantification adaptative. Il comporte pour cela un circuit 20 d'extraction d'un descripteur du spectre suivi d'un quantificateur 22, qui met le descripteur sous une forme constituant une information auxiliaire transmise au décodeur du récepteur. Le descripteur quantifié est également appliqué, dans le codeur, à un circuit 24 d'allocation à chaque coefficient d'un nombre de bits tenant compte de son amplitude. Les coefficients y(m,k) de chaque bloc sont numérisés par des quantificateurs adaptatifs 26 qui codent chaque coefficient avec un nombre de bits fixé par le circuit d'allocation 24.

Les coefficients quantifiés et le descripteur quantifié sont envoyés à des moyens de formatage, un modulateur et à des circuits de sortie (non représentés).

Le récepteur comporte des circuits d'entrée non représentés effectuant une démodulation et une répartition de l'information reçue, le format des messages étant mémorisé dans ces circuits d'entrée. Ces circuits alimentent le décodeur 12 de constitution symétrique de celle du codeur. Les coefficients quantifiés sont envoyés à un quantificateur inverse 28 tandis que les descripteurs sont appliqués à un circuit 30 de reconstitution du descripteur qui alimente un circuit 32 d'allocation de bits suivant une répartition identique à celle du codeur.

A partir des coefficients quantifiés reçus et de l'information auxiliaire sur le spectre, le quantificateur inverse 28 fournit, pour chaque bloc d'échantillons, N/2 coefficients y'(m,k). Ces coefficients restitués sont appliqués à un circuit 34 de TFD inverse ou TFD$^{-1}$ qui restitue, à son tour, N échantillons x'(m) pour chaque bloc. Ces N échantillons reproduisent les échantillons d'entrée, si ce n'est qu'ils sont affectés d'un bruit dû à la quantification et à la fonction de transfert de la voie de transmission.

Comme on l'a vu plus haut, une installation suivant l'invention comporte des moyens supplémentaires utilisant la stationnarité du signal à plus long terme que la durée d'un bloc, qui se traduit par une redondance de certains au moins des coefficients de la transformée.

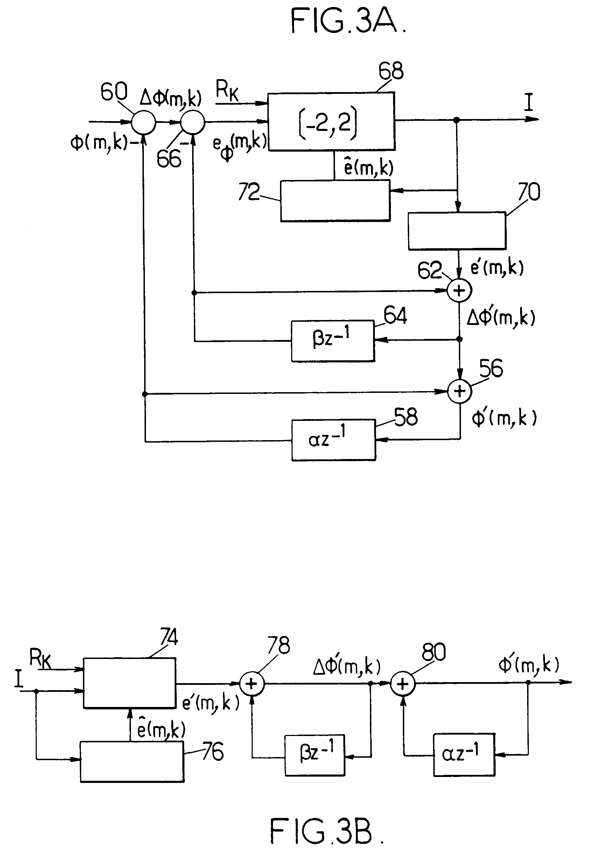

On décrira d'abord une constitution possible d'un codeur et d'un décodeur prédictifs du module des harmoniques (Figures 2A et 2B) et d'un codeur et d'un décodeur prédictifs de la phase des harmoniques (Figures 3A et 3B) avant de donner une constitution possible globale de l'installation. Dans le cas particulier considéré, on considèrera que le codage est du type MICDA (modulation par impulsions codées différentielle adaptative), dite aussi ADPCM, mais d'autres modes de codage seraient également utilisables.

## Codage et décodage prédictifs du module des harmoniques

Le codeur prédictif du module de chaque coefficient peut avoir la constitution montrée en figure 2A. Le module, fourni par le circuit de transformation 18, est appliqué à un additionneur 36 qui reçoit également la prédiction $\hat{y}$, fournie par une boucle différentielle de prédiction, sur son entrée soustractive. L'erreur de prédiction e(m,k) fournie par l'additionneur 36 est appliquée à un quantificateur 40 qui restitue, à sa sortie, l'erreur de prédiction sous forme d'un signal binaire représentant un niveau de quantification.

La boucle de prédiction représentée comporte un quantificateur inverse 42 et un additionneur algébrique 44. L'additionneur 44 reçoit le signal d'erreur reconstitué e'(m,k) et la sortie d'un prédicteur 46 alimentée par la sortie de l'additionneur 44.

En règle générale, la boucle de prédiction sera d'ordre p=1 avec un coefficient de prédiction fixe, un ordre de prédiction plus élevé n'apportant en général qu'une faible amélioration du gain de prédiction.

La sortie du quantificateur 40 est également appliquée à un bloc d'adaptation 45 qui fournit au quantificateur une estimée de l'écart type ê(m,k).

Le quantificateur 40 et le bloc d'adaptation 45 peuvent être prévus pour réaliser l'adaptation par la technique des multiplieurs, dont une description est donnée dans "Digital coding of waveforms" par N. Jayant et autres, Prentice Hall Signal Processing Series, Editions Oppenheim. Le quantificateur 40 fonctionne de la façon suivante : pour traiter le bloc m, la valeur estimée ê(m,k) est multipliée par un facteur qui dépend du mot de code I(m-1,k) transmis en sortie du multiplicateur pour le bloc m-1, suivant la relation :

$$\hat{e}_m(m,k) = \hat{e}_m(m-1,k).M\mu(|I(m-1,k)|)$$

Les valeurs de $M\mu(|I|)$ sont précalculées et stockées dans des tables mémorisées dans le bloc d'adaptation 45.

Le quantificateur est de type non uniforme adaptatif, selon la loi de Laplace. Le nombre de niveaux, représentés par des mots de code, qu'il peut fournir en sortie varie en fonction de m et de k, suivant une allocation dynamique des bits dont le nombre $R_k$ est fourni sur une entrée 48.

Pour que l'énergie de l'erreur e(m,k) en sortie de l'additionneur 36 soit minimale, le coefficient de prédiction fixe de la boucle doit être égal au coefficient de corrélation $\rho$. L'expérience a montré que $\rho$ est égal à environ 0,96 pour un signal audio.

Si on désigne par y'(m-1,k) le module reconstitué à partir des mots de code I transmis pour le bloc d'ordre m-1, les équations décrivant le fonctionnement du codeur prédictif du module sont les suivantes :

$$e(m,k) = |y(m,k)| - \rho.|y'(m-1,k)|$$
$$|y'(m,k)| = e'_m(m,k) + \rho.|y'(m-1,k)|$$

ou e'(m,k) désigne la sortie du quantificateur inverse, égale à l'erreur e (m,k) au bruit de quantification près.

Le décodeur prédictif du module contenu dans le récepteur peut avoir la constitution de principe montré en figure 2B : le signal démodulé reçu est appliqué à un quantificateur MIC inverse 50 muni d'un circuit d'adaptation 52 identique à celui du codeur. Le circuit d'adaptation fournit au quantificateur inverse une estimation de l'écart type ê(m,k). La synthèse du module reconstitué y'(m,k) est effectuée par intégration de l'erreur reconstituée e'(m,k) dans un additionneur 54 qui reçoit également la sortie d'une boucle de prédiction dont le coefficient de prédiction est le même que celui du prédicteur 46.

## Codeur et décodeur prédictifs de la phase des harmoniques

Le codeur prédictif de phase (figure 3A) a une constitution générale similaire à celle du codeur de la figure 2A mais comporte deux boucles différentielles.

La boucle externe, constituée d'un additionneur algébrique 56, d'un prédicteur 58 et d'un additionneur 60, calcule la différence des phases $\Delta\varphi(m,k)$, représentative de la fréquence d'après la formule (4) ci-dessus.

La boucle interne, constituée d'un additionneur algébrique 62, d'un prédicteur 64 et d'un additionneur 66, permet d'obtenir l'erreur $e\varphi$. On voit que l'additionneur 66 reçoit un signal représentatif de la fréquence, provenant de l'additionneur 60, et une prédiction de la fréquence instantanée, fournie par le prédicteur 64.

La prédiction est d'ordre 1, comme dans le cas du codeur du module. Un ordre de prédiction plus élevé n'améliore le gain de prédiction que pour des cas particuliers, tels qu'un vibrato. Il n'est donc en général pas justifié.

Le coefficient de prédiction $\beta$ pour la boucle interne est en principe égal au coefficient de corrélation : une valeur $\beta = 0{,}97$ donne de bons résultats. Le coefficient $\alpha$ de la boucle externe est choisi de façon à atténuer les effets des erreurs de transmission. Une valeur de 0,98 donne souvent de bons résultats.

On ne décrira pas la constitution du quantificateur 68, du quantificateur inverse 70 et du circuit d'adaptation 72, qui peut être la même que celle du codeur du module. L'adaptation est encore réalisée par les multiplieurs. La quantification peut être uniforme sur un intervalle déterminé, par exemple [-2,+2].

Le fonctionnement du codeur est représenté par les équations suivantes :

$$\Delta\varphi(m,k) = \varphi(m,k) - \alpha.\varphi'(m-1,k)$$
$$e\varphi(m,k) = \Delta\varphi(m,k) - \beta.\Delta\varphi'(m-1,k) \quad (7)$$
$$\Delta\varphi'(m,k) = e'_\phi(m,k) + \beta.\Delta\varphi'(m-1,k)$$
$$\varphi'(m,k) = \Delta\varphi'(m,k) + \alpha.\varphi'(m-1,k)$$

La fonction de transfert du décodeur dans son ensemble est :

$$H(z) = \frac{z^2}{(z-\alpha).(z-\beta)} \quad (8)$$

La stabilité du décodeur est assurée puisque $\alpha$ et $\beta$ ont l'un et l'autre une valeur absolue inférieure à 1.

Le codeur prédictif montré en figure 3A doit en général être complété par des moyens de test (non représentés) permettant de détecter les sauts de phase. En effet la valeur de $\varphi(m,k)$ n'est disponible que modulo $2\Pi$. Un saut de phase de $\pm\Pi$ se produit régulièrement dans le cas d'un signal périodique et se traduit par une impulsion sur l'erreur $e\varphi(m,k)$. Pour éviter que cette impulsion rompe la continuité de la phase $\varphi(m,k)$ et de la différence de phase $(\Delta\varphi)$, un recadrage est nécessaire.

Les moyens de test peuvent comparer la valeur absolue de l'erreur e(m,k) à $\Pi$. Si la valeur absolue dépasse $\Pi$, les moyens recherchent laquelle des trois valeurs possibles:

$$\Delta\varphi(m,k)$$
$$\Delta\varphi(m,k) + 2\Pi$$
$$\Delta\varphi(m,k) - 2\Pi$$

minimise la valeur absolue de l'erreur $e\varphi(m,k)$.

La modification apportée à $\Delta\varphi$ donne à la phase synthétisée par l'additionneur 56 un module de valeur supérieure à $\Pi$ : le codeur est alors recadré pour maintenir $\varphi'(m,k)$ dans les limites $[-\Pi,+\Pi]$.

Le décodeur prédictif de la phase (Figure 3B)) a une constitution symétrique de celle du codeur. Il comporte un quantificateur inverse 74 muni d'un adaptateur 76, qui attaque un additionneur 78 appartenant à une boucle de prédiction pour reconstituer la différence de phase $\Delta\varphi'$. Une seconde boucle de prédiction, en aval de la première, comporte un additionneur 80 qui permet d'obtenir la phase $\varphi'(m,k)$ reconstituée.

On voit que la phase codée $\varphi'(m,k)$ est obtenue par double intégration de l'erreur de prédiction transmise sous forme de mots codés I. Comme le codeur, le décodeur prédictif de la phase comporte en général des moyens de test sur la phase synthétisée et de recadrage (non représentés).

Pour une précision donnée de quantification, la transmission des mots obtenus par le codage MICDA réclame un débit moindre que la transmission directe du module ou de la phase des coefficients, du moins pour les coefficients proches des pics du spectre de fréquence. Globalement, le gain pour l'ensemble des signaux audio est d'environ 2 bits pour chaque valeur prédite (module et phase).

Il est important de relever que le gain global de prédiction obtenu par codage MICDA du module et de la phase est dû au degré de prédictibilité élevé des coefficients proches des pics du spectre de fréquence. Le gain de prédiction pour les coefficients correspondant à des raies spectrales moins énergétiques est faible. Il peut même être négatif.

Le codage prédictif n'est mis en oeuvre que pour les coefficients présentant une redondance à long terme élevée. Cela implique une discrimination fréquentielle préalable. Elle peut se faire à l'aide d'une estimée récursive du spectre $|y_e(m,k)|$, calculée par :
$$|y_e(m,k)| = h_1.|y_e(m-1,k)| + (1-h_1).|y'(m-1,k)|$$
et d'une estimation récursive de l'erreur de prédiction $e_c(m,k)$, calculée par :
$$e_c(m,k) = h_1.e_c(m-1,k) + (1-h_1).|e'(m-1,k)|$$
où $e'()$ est l'erreur de prédiction quantifiée au bloc précédent et $h_1$ est une constante comprise entre 0 et 1 (par exemple $h_1 = 0,6$).

Les raies prédictibles sont alors détectées par comparaison du gain de prédiction $(|y_e(m,k)|/e_c(m,k))^2$ à un seuil fixe, choisi de façon à assurer par exemple un gain minimal de 1 bit par valeur prédite.

Puisque $(|y_e(m,k)|$ et $e_c(m,k)$ sont aussi connus au décodeur, il n'y a pas d'information auxiliaire à transmettre.

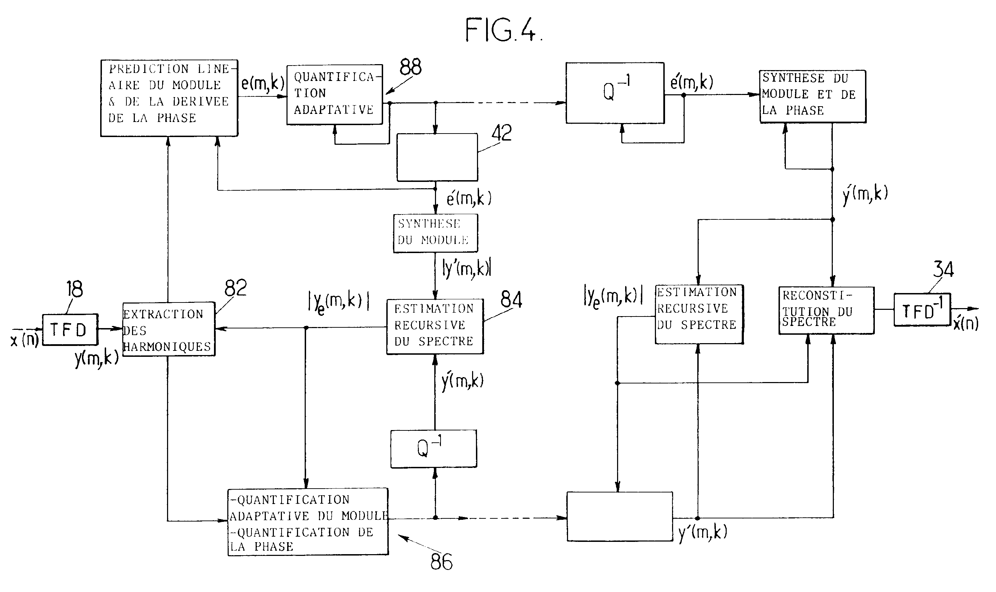

La Figure 4 montre une constitution possible d'installation mettant en oeuvre une telle discrimination fréquentielle, dont le codeur (comme le décodeur) a deux branches dont une seule met en oeuvre un codage (ou un décodage) prédictif de type MICDA. Les éléments de la Figure 4 correspondant à ceux déjà montrés sur les Figures 1 à 3 ne seront pas décrits de nouveau et les additionneurs ne sont pas illustrés pour plus de simplicité.

Dans le codeur, un circuit d'extraction d'harmoniques 82 oriente les coefficients soit vers la branche sans prédiction, soit vers la branche à codage MICDA du module et de la phase, en fonction du signal d'adaptation reçu d'un circuit 84 d'estimation récursive du spectre. Ce signal est constitué par l'estimation récursive $|y_e(m,k)|$ qu'il n'est pas nécessaire de transmettre.

Dans la branche sans prédiction 86, la phase $\varphi(m,k)$ est quantifiée de façon uniforme sur l'intervalle $[-\Pi,\Pi]$ et le module est quantifié de façon adaptative non uniforme (loi de Laplace).

Dans la branche à prédiction 88, le codage prédictif des caractéristiques fréquentielles réduit le débit à allouer aux coefficients les plus significatifs du spectre et sa combinaison avec une quantification adaptative bouclée, ou "backward", aboutit à un algorithme de codage où l'information auxiliaire est très réduite. Le gain du à la prédiction de certaines raies du spectre est pris en compte dans la procédure qui alloue les bits à chacun des coefficients de la transformée. Cette procédure est calculée pour chaque bloc d'échantillons et son principe est conforme aux techniques décrites dans l'article de Zelinski et autres "Adaptive Transform Coding of Speech Signals", IEEE Trans. on ASSP, Août 1977, et dans celui de Johnston "Transform Coding of Audio using Perceptual Criteria", IEEE Journal on Selected Areas in Communications, Février 1988.

Toutefois, à importance égale, les valeurs prédites, module ou phase, reçoivent un nombre de bits moindre. La différence $\Delta R_k$ peut être fixe et égale au gain moyen (ou minimal) du à la prédiction par exemple $\Delta R_k = $ 2bits.

Cependant, pour un fonctionnement optimal, on est amené à calculer $\Delta R_k$ en fonction du gain de prédiction instantané pour chacune des raies prédictibles. $\Delta R_k$ est alors variable en fréquence et en temps. $\Delta R_k$ peut être alors obtenu d'après le rapport $(|y_e(m,k)|/e_c(m,k))^2$.

L'allocation des bits étant entièrement calculée d'après $|y_e(m,k)|$ et $e_c(m,k)$, il n'y a pas d'information auxiliaire à transmettre.

Des sons différents, tels les signaux résonnants ou les signaux à spectre plat, sont codés par le même algorithme sans nécessiter de classification préalable.

**Revendications**

1. Procédé de transmission ou stockage, sous forme numérique, de signaux sonores, suivant lequel on découpe le signal sonore en blocs d'échantillons et on soumet les échantillons de chaque bloc à un codage par transformée temps-fréquence dont on transmet les coefficients sous forme numérique, les opérations inverses étant effectuées à la réception, caractérisé en ce qu'on soumet au moins les coefficients les plus significatifs de la transformée de chaque bloc à un codage prédictif et adaptatif utilisant la stationnarité du signal sur une durée supérieure à celle d'un bloc, les coefficients étant soumis à une discrimination fréquentielle et seuls ceux présentant une redondance à long terme élevée sur une durée supérieure à celle d'un bloc étant soumis au codage prédictif et adaptatif.

2. Procédé selon la revendication 1, caractérisé en ce que ledit codage prédictif et adaptatif est appliqué au module et à la phase desdits coefficients.

3. Procédé selon la revendication 1 ou 2, caractérisé en ce que le codage prédictif et adaptatif est de type MICDA.

4. Codeur de signaux sonores pour mise en oeuvre du procédé de transmission ou stockage selon la revendication 1, caractérisé en ce qu'il comprend, en aval d'un circuit (18) de transformation temps-fréquence, des moyens de codage prédictif et adaptatif de certains au moins des coefficients de la transformée de chaque bloc comprenant :
   - des moyens (82) de discrimination fréquentielle à circuit d'estimation du spectre pour sélectionner les coefficients de la transformée de chaque bloc à coder,
   - un codeur (40, 42, 44, 45, 46) de module d'ordre de prédiction au moins d'ordre 1, ayant un quantificateur non uniforme,
   et
   - un codeur (56, 58, 60, 62, 64, 66, 68, 70, 72) de la phase à prédiction au moins d'ordre 1 de la fréquence instantanée, ayant un quantificateur uniforme, une boucle différentielle externe de calcul de différence de phases et une boucle interne de calcul d'erreur.

5. Codeur selon la revendication 4, caractérisé en ce que le codeur de module comprend un quantificateur MIC (40), une boucle de prédiction ayant un quantificateur inverse (42), un additionneur algébrique (44) rebouclé par l'intermédiaire d'un multiplieur par un coefficient $\rho$ de prédiction et un additionneur d'entrée du quantificateur, de façon à fonctionner suivant les équations :
$$e(m,k) = \left| y(m,k) \right| - \rho. \left| y'(m-1,k) \right|$$
$$\left| y'(m,k) \right| = e'_m(m,k) + \rho. \left| y'(m-1,k) \right|$$
ou e'(m,k) désigne la sortie du quantificateur inverse, égal à l'erreur e (m,k) au bruit de quantification près, où y est la valeur de module à coder, y' est la valeur estimée de y, et m est le numéro d'ordre du bloc.

6. Codeur selon la revendication 5, caractérisé en ce que $\rho$ est de l'ordre de 0,96.

7. Codeur selon la revendication 4, 5 ou 6, caractérisé en ce que la boucle interne du codeur de phase comprend un quantificateur inverse, un additionneur algébrique (62) rebouclé par l'intermédiaire d'un prédicteur (64) à multiplication par un coefficient $\beta$ sensiblement égal au coefficient de corrélation entre blocs et un additionneur (66) d'entrée du quantificateur.

8. Codeur selon la revendication 7, caractérisé en ce que les moyens additionneurs (66) comportent un additionneur algébrique, des moyens pour effectuer un test de comparaison de l'erreur à $\Pi$ et des moyens de recadrage de la phase pour la maintenir dans le domaine [-$\Pi$, +$\Pi$].

9. Codeur selon la revendication 7 ou 8, caractérisé en ce que la boucle externe est constituée d'un additionneur algébrique (56), d'un prédicteur (58) à multiplication par un coefficient inférieur à 1 d'atténuation d'erreurs et de moyens additionneurs (60).

10. Décodeur de signaux sonores adapté pour coopérer avec le codeur suivant l'une quelconque des revendications 4 à 9, caractérisé en ce qu'il comprend, en amont d'un circuit de transformation fréquence-temps, des moyens de décodage ayant
   - un décodeur de module (50, 52, 54) de constitution symétrique de celle du codeur de module, et

- un décodeur prédictif de phase (74, 76, 78, 80) ayant deux boucles de prédiction en cascade, reconstituant successivement la différence de phase et la phase.

11. Décodeur selon la revendication 10, caractérisé en ce que le décodeur prédictif de phase comprend des moyens additionneurs ayant un additionneur algébrique (80) associé à des moyens de recadrage de la phase φ(m,k).

12. Installation de transmission comprenant un codeur selon l'une des revendications 4 à 9, caractérisé en ce qu'elle comprend une branche supplémentaire (86) sans moyens de codage prédictif adaptatif pour assurer, suite à la discrimination fréquentielle des coefficients, la transmission sans prédiction des coefficients de faible énergie.


**Patentansprüche**

1. Verfahren zur Übertragung oder Speicherung von Schallsignalen in numerischer Form, gemäß welchem man das Schallsignal in Probenblöcke zerlegt und man die Proben jedes Blocks einer Kodierung mittels Zeit-Frequenz-Transformation unterwirft, deren Koeffizienten man in numerischer Form überträgt, wobei empfangsseitig die Umkehroperationen durchgeführt werden, **dadurch gekennzeichnet**, daß man wenigstens die bedeutsamsten Koeffizienten der Transformierten jedes Blocks einer prognostischen und adaptiven Kodierung unterwirft, welche die Stationarität des Signals über eine oberhalb der Dauer eines Blocks liegende Dauer verwendet, wobei die Koeffizienten einer Frequenz-Diskriminierung unterworfen werden und lediglich jene Koeffizienten der prognostischen und adaptiven Kodierung unterworfen werden, die über eine oberhalb der Dauer eines Blocks liegende Dauer eine erhöhte langfristige Redundanz aufweisen.

2. Verfahren nach Anspruch 1, **dadurch gekennzeichnet**, daß die prognostische und adaptive Kodierung auf den Betrag und die Phase der Koeffizienten angewendet wird.

3. Verfahren nach Anspruch 1 oder 2, **dadurch gekennzeichnet**, daß die prognostische und adaptive Kodierung vom ADPCM-Typ ist.

4. Kodierer für Schallsignale zur Durchführung des Verfahrens zur Übertragung oder Speicherung nach Anspruch 1, **dadurch gekennzeichnet,** daß er stromaufwärts einer Zeit-Frequenz-Transformationsschaltung (18) Mittel umfaßt zur prognostischen und adaptiven Kodierung wenigstens von bestimmten der Koeffizienten der Transformierten jedes Blocks, umfassend:
   - Frequenzdiskriminierungs-Mittel (82) mit einer Schaltung zur Bewertung des Spektrums, um die zu kodierenden Koeffizienten der Transformierten jedes Blocks auszuwählen,
   - einen Betrags-Kodierer (40, 42, 44, 45, 46) einer Vorhersageordnung wenigstens 1. Ordnung, der einen nicht gleichmäßigen Quantisierer aufweist, und
   - einen Phasen-Kodierer (56, 58, 60, 62, 64, 66, 68, 70, 72) einer Vorhersageordnung wenigstens 1. Ordnung, der einen gleichmäßigen Quantisierer, eine äußere Differentialschleife zur Berechnung der Phasendifferenz und eine innere Schleife zur Fehlerberechnung aufweist.

5. Kodierer nach Anspruch 4, **dadurch gekennzeichnet**, daß der Betrags-Kodierer einen PCM-Quantisierer (40), eine Vorhersageschleife mit einer Quantisierungsumkehrvorrichtung (42), einen algebraischen Addierer (44), der vermittels eines Multiplizierers mit einem Vorhersagekoeffizienten $\vartheta$ rückgekoppelt ist, und einen Eingangsaddierer des Quantisierers umfaßt, so daß er gemäß den folgenden Gleichungen arbeitet:

$$e(m,k) \ = \ \big|y(m,k)\big| \ - \ \rho \cdot \big|y'(m-1,k)\big|$$
$$\big|y'(m,k)\big| \ = \ e'_m(m,k) \ + \ \rho \cdot \big|y'(m-1,k)\big|$$

wobei e'(m,k) das Ausgangssignal der Quantisierungsumkehrvorrichtung bezeichnet, der abgesehen vom Quantisierungsrauschen gleich dem Fehler e(m,k) ist, wobei y der Wert des zu kodierenden Betrags ist, y' der Schätzwert von y ist, und m die Ordnungszahl des Blocks ist.

6. Kodierer nach Anspruch 5, **dadurch gekennzeichnet**, daß $\vartheta$ in der Größenordnung von 0,96 liegt.

7. Kodierer nach Anspruch 4, 5 oder 6, **dadurch gekennzeichnet**, daß die innere Schleife des Phasen-Kodierers eine Quantisierungsumkehrvorrichtung, einen algebraischen Addierer (62), der vermittels einer Vorhersagevorrichtung (64) mit Multiplikation mit einem Koeffizienten β rückgekoppelt ist, wobei der Koeffizient β im wesentlichen gleich dem Korrelationskoeffizienten zwischen Blöcken ist, und einen Eingangsaddierer (66) des Quantisierers umfaßt.

8. Kodierer nach Anspruch 7, **dadurch gekennzeichnet**, daß die Addierermittel (66) einen algebraischen Addierer, Mittel zum Durchführen eines Vergleichstests des Fehlers mit $\pi$ und Mittel zum Zurückführen der Phase umfassen, um die Phase in dem Bereich $[-\pi, +\pi]$ zu halten.

9. Kodierer nach Anspruch 7 oder 8, **dadurch gekennzeichnet**, daß die äußere Schleife von einem algebraischen Addierer (56), einer Vorhersagevorrichtung (58) mit Multiplikation mit einem Fehlerdämpfungskoeffizienten, der kleiner als 1 ist, und Addierermitteln (60) gebildet ist.

10. Dekodierer von Schallsignalen, der zum Zusammenwirken mit dem Kodierer gemäß einem der Ansprüche 4 bis 9 geeignet ist, **dadurch gekennzeichnet**, daß er stromabwärts einer Frequenz-Zeit-Transformationschaltung Mittel zum Dekodieren aufweist, umfassend
    - einen Betrags-Dekodierer (50, 52, 54) mit einem zum Aufbau des Betrags-Kodierers symmetrischen Aufbau und
    - einen prognostischen Phasen-Dekodierer (74, 76, 78, 80) mit zwei in Reihe angeordneten Vorhersageschleifen, welche aufeinanderfolgend die Phasendifferenz und die Phase rekonstruieren.

11. Dekodierer nach Anspruch 10, **dadurch gekennzeichnet**, daß der prognostische Phasen-Dekodierer Addierermittel mit einem algebraischen Addierer (80) umfaßt, der den Mitteln zum Zurückführen der Phase φ(m,k) zugeordnet ist.

12. Übertragungseinrichtung, umfassend einen Kodierer nach einem der Ansprüche 4 bis 9, **dadurch gekennzeichnet**, daß sie einen zusätzlichen Zweig (86) ohne prognostische adaptive Kodier-Mittel umfaßt, um anschließend an die Frequenzdiskriminierung der Koeffizienten die vorhersagefreie Übertragung der Koeffizienten schwacher Energie sicherzustellen.


## Claims

1. Method of transmitting or storing sound signals in digital form, in which the sound signal is chopped up into blocks of samples and the samples of each block are subjected to time-frequency transform coding the coefficients of which are transmitted in digital form, the reverse operations taking place at reception, characterised by subjecting at least the most significant coefficients of said transform of each block to predictive and adaptive coding using the stationary state of the signal over a duration greater than that of one block, said coefficients being subjected to frequency discrimination, only those presenting a high long term redundancy over a time duration greater than that of a block being subjected to said predictive and adaptive coding.

2. The method according to claim 1, characterised by said predictive and adaptive coding being applied to the module and the phase of said coefficients.

3. Method according to claim 1 or 2, characterised by said adaptive coding being of ADCPM type.

4. Sound signal encoder for implementing the method of transmitting or storing according to claim 1, characterised by said encoder comprising downstream of a time-frequency transformation circuit (18), means for predictive and adaptive coding of at least some of the coefficients of said transform of each block, said coding means comprising :
    - means (82) for frequency discrimination having a spectral estimation circuit for selecting said transform coefficients of each block to be encoded,
    - a module encoder (40,42,44,45,46) of a prediction order of at least order 1, having a non-uniform quantifier, and
    - a phase encoder (56,58,60,62,64,66,68,70,72), with prediction at least of order 1 of the instantaneous frequency having a uniform quantifier, a differential external loop for computing the phase difference and an error computing internal loop.

5. Encoder according to claim 4, characterised by a module encoder comprising a MIC quantifier (40), a prediction loop having a reverse quantifier (42), an algebric adder (44) relooped via a multipler multiplying by a prediction coefficient $\rho$ and an input adder of the quantifier, so as to operate in accordance with the equations :

$$e(m,k) = |y(m,k)| - \rho.|y'(m - 1,k)|$$
$$|y'(m,k)| = e'_m(m,k) + \rho.|y'(m - 1,k)|$$

where e'(m,k) designates the output of the reverse quantifier, equal to the error e(m,k) except for the quantification noise, where y is the value of the module to be coded, y' is the estimated value of y and m is the order number of the block.

6. Encoder according to claim 5, characterised by $\rho$ being about 0.96.

7. Encoder according to one of claims 4, 5 or 6, characterised by said internal loop of the phase encoder comprising a reverse quantifier, an algebric adder (62) relooped through a predictor (64) multiplying by a coefficient $\beta$ substantially equal to the correlation coefficient between blocks and an input adder (66) of the quantifier.

8. Encoder according to claim 7, characterised by adding means (66) comprising an algebric adder, means for carrying out a comparison test of the error with $\pi$ and means for resetting the phase so as to maintain it in the range [-$\pi$, +$\pi$].

9. Encoder according to claim 7 or 8, characterised by said external loop consisting of an algebric adder (56), a predictor (58) with a multiplication by a coefficient less than 1 for the error attenuation and adder means (60).

10. Sound signal decoder for cooperation with the encoder according to one of claims 4 to 9, characterised by said decoder comprising, upstream of a frequency-time transformation circuit, decoding means having
    - a module decoder (50,52,54) whose construction is symmetrical with that of the module encoder, and
    - a predictive phase decoder (74,76,78,80) having two prediction loops cascade connected, reconstituting successively the phase difference and the phase.

11. Decoder according to claim 10, characterised by said predictive phase decoder comprising adder means having an algebric adder (80) associated with means for resetting the phase $\varphi(m,k)$.

12. Transmission installation comprising a sound signal encoder according to one of claims 4 to 9, characterised by said transmission installation comprising an additional branch (86) without predictive adaptive coding and frequency discrimination means for transmitting coefficients of low energy, after said coefficient frequency discrimination.

FIG.1.

FIG.2A.

FIG.2B.

# FIG.3A.

# FIG.3B.

# FIG.4.